# EUROPEAN PATENT SPECIFICATION

(11) **EP 2 366 195 B1**
(45) Date of publication and mention of the grant of the patent: **18.01.2017**
(21) Application number: 09798979.2
(22) Date of filing: 07.12.2009
(51) Int. Cl.: H01L 27/148

(54) **IMAGE SENSORS WITH LATERAL OVERFLOW DRAINS**
BILDSENSOREN MIT SEITLICHEN ÜBERLAUF-SENKEN
CAPTEURS D'IMAGE À DRAINS DE TROP-PLEINS LATÉRAUX

(30) Priority: 10.12.2008 US 121249 P; 30.10.2009 US 609257
(43) Date of publication of application: 21.09.2011
(73) Proprietor: Semiconductor Components Industries, LLC, Phoenix, AZ 85008 (US)
(72) Inventor: BANGHART, Edmund, Kenneth, Rochester, New York 14650 (US); STEVENS, Eric, Gordon, Rochester, New York 14650 (US); DOAN, Hung Quoc, Rochester, New York 14650 (US)
(74) Representative: Clarke, Geoffrey Howard
(86) International application number: PCT/US2009/006415
(87) International publication number: WO 2010/068252

(56) References cited:
- EP-A2- 1 289 019
- JP-A- 56 049 577
- US-A- 4 362 575
- US-A- 4 579 626
- US-A- 4 607 429
- US-A- 5 585 298
- US-A1- 2002 140 003
- US-B1- 6 794 219

## Description

### TECHNICAL FIELD

The present invention relates generally to image sensors for use in digital cameras and other types of image capture devices, and more particularly to CCD image sensors having lateral overflow drain and channel stop regions.

### BACKGROUND

A typical electronic image sensor includes a number of photosensitive picture elements ("pixels") arranged in a two-dimensional array.

The pixels accumulate charge carriers in response to light striking the pixels, and each pixel has a maximum amount of charge it can store. A phenomenon known as "blooming" occurs when the total number of charge carriers collected by a pixel exceeds the charge capacity for that pixel and the excess charge spills over into adjacent pixels. One known anti-blooming technique forms a lateral overflow drain (LOD) within a pixel to provide a means for draining the excess charge carriers from the pixel before the charge carriers spill into adjacent pixels.

Document US 5 585 298 describes a self aligned antiblooming structure for an image sensor including an overflow drain and an antiblooming potential barrier.

Document US 6 794 219 similarly describes a method for fabricating an antiblooming structure in a charge coupled device.

Document US 2002/140003 discloses a method for fabricating a charge coupled device having a lateral overflow drain.

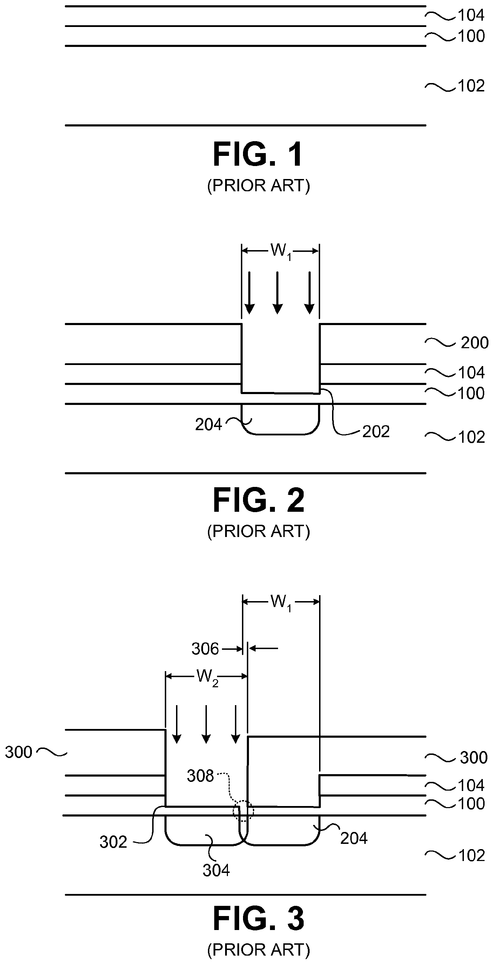

**FIGS. 1-3** depict a method of forming lateral overflow drain and channel stop regions in accordance with the prior art. Initially, as shown in **FIG. 1**, an insulating layer 100 is formed over a substrate or well 102. A nitride layer 104 is then formed over the insulating layer 100.

**FIG. 2** illustrates mask layer 200 formed on nitride layer 104 and patterned to form an opening having a width W₁. The portion of nitride layer 104 that is exposed in the opening is etched away. Nitride layer 104 is commonly over etched to accommodate for variations in the thickness of nitride layer 104. This overetching removes a portion 202 of insulating layer 100. A dopant is then implanted into substrate 102 (represented by arrows) to form channel stop 204. Channel stop 204 prevents charge carriers from spilling to horizontally adjacent pixels.

Mask layer 200 is then removed and another mask layer 300 is formed on the remaining nitride layer 104 and the exposed portion of insulating layer 100 (**FIG. 3**). Mask layer 300 is patterned to form an opening having a width W₂, and the portion of nitride layer 104 exposed in the second opening is etched away. Again, nitride layer 104 is typically over etched to account for variations in the thickness of nitride layer 104, thereby removing another portion 302 of insulating layer 100. A dopant is then implanted into substrate 102 (represented by arrows) to form lateral overflow drain 304.

To ensure that all of nitride layer 104 that overlies the lateral overflow drain region is removed prior to the formation of the lateral overflow drain 302, W₂ typically overlaps with W₁, creating overlap area 306. When nitride layer 104 is etched as shown in **FIGS. 2** and **3**, the portion 308 of insulating layer 100 located in overlap area 306 is etched twice. This double-etching can remove portion 308 completely, thereby exposing the top surface of substrate 102 and allowing the substrate surface to be damaged during subsequent processing steps. Exposing or damaging the top surface of substrate 102 can potentially result in contamination of substrate 102 and produce defects in the image sensor, such as, for example, cluster defects.

### SUMMARY

A lateral overflow drain and a channel stop of a CCD image sensor are fabricated using a double mask layer process according to claim 1.

In this process a first mask layer is formed over an insulating layer. The insulating layer is disposed on a substrate, layer, or well having a first conductivity type. The first mask layer is patterned to create one or more first openings. A dopant or dopants having the same conductivity type as the substrate, layer, or well are then implanted through the first openings and into the substrate, layer, or well to form one or more channel stops.

A second mask layer is then formed on the first mask layer and patterned to create one or more second openings. Each second opening is disposed in a portion of a respective first opening, and a portion of the second mask layer is disposed in the remaining portion of the first opening. One or more dopants having a second conductivity type opposite the first conductivity type are then implanted through each second opening and into each channel stop to form a lateral overflow drain. Due to the dual-mask layers, only one edge of a footprint of each lateral overflow drain is aligned with an edge of a footprint of a respective channel stop. The first and second mask layers are then removed and the device processed further using known fabrication steps.

### ADVANTAGEOUS EFFECT OF THE INVENTION

The present invention includes the advantage of forming one or more lateral overflow drains without damaging any underlying layers. Additionally, the present invention provides accurate and repeatable methods for fabricating lateral overflow drains and channel stops with minimal feature sizes. This is particularly beneficial in high resolution image sensors.

### BRIEF DESCRIPTION OF THE DRAWINGS

Embodiments of the invention are better understood with reference to the following drawings. The elements of the drawings are not necessarily to scale relative to each other.
**FIGS. 1-3** depict a method of forming lateral overflow drain and channel stop regions in accordance with the prior art;
**FIG. 4** is a simplified block diagram of an image capture device in an embodiment in accordance with the invention;
**FIG. 5** is a simplified block diagram of image sensor 406 shown in **FIG. 4** in an embodiment in accordance with the invention;
**FIG. 6** is a simplified diagram of pixel 500 shown in **FIG. 5** in an embodiment in accordance with the invention;
**FIGS. 7-12** are cross section views of a portion of pixel 500 along line A-A' in **FIG. 6** illustrating a method of forming lateral overflow drain 610 and channel stop 608 according to an example not forming part of the claimed invention; and
**FIGS. 13-15** are cross section views of a portion of pixel 500 along line A-A' in **FIG. 6** illustrating alternate techniques that can be performed instead of the techniques shown in **FIGS. 8-10** in an embodiment in accordance with the invention.

### DETAILED DESCRIPTION

Throughout the specification and claims, the following terms take the meanings explicitly associated herein, unless the context clearly dictates otherwise. Directional terms such as "on", "over", "top", "bottom", are used with reference to the orientation of the Figure(s) being described. Because components of embodiments of the present invention can be positioned in a number of different orientations, the directional terminology is used for purposes of illustration only and is in no way limiting. When used in conjunction with layers of an image sensor wafer or corresponding image sensor, the directional terminology is intended to be construed broadly, and therefore should not be interpreted to preclude the presence of one or more intervening layers or other intervening image sensor features or elements. Thus, a given layer that is described herein as being formed on or formed over another layer may be separated from the latter layer by one or more additional layers.

Additionally, the terms "wafer" and "substrate" are to be understood as a semiconductor-based material including, but not limited to, silicon, silicon-on-insulator (SOI) technology, doped and undoped semiconductors, epitaxial layers formed on a semiconductor substrate, and other semiconductor structures.

Referring to the drawings, like numbers indicate like parts throughout the views.

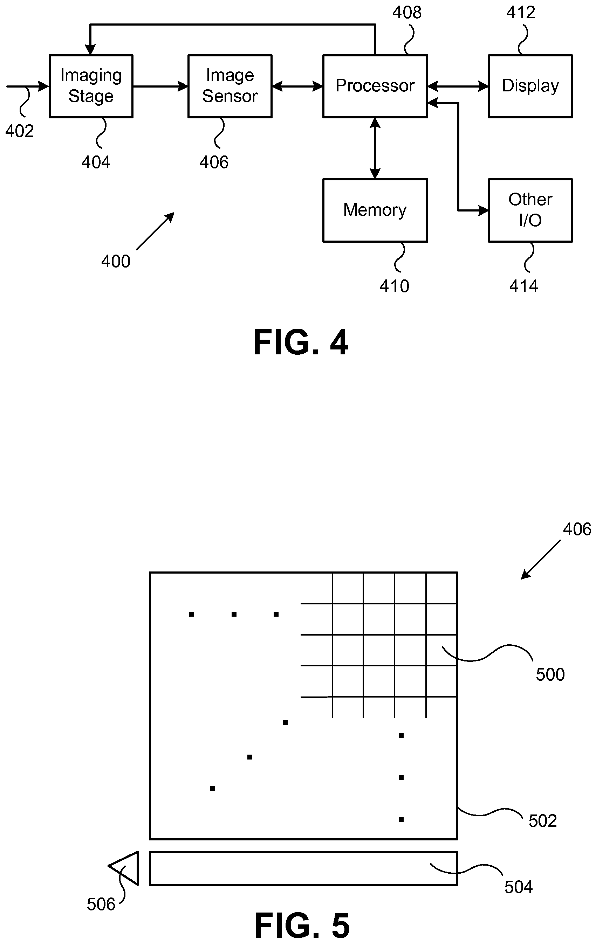

**FIG. 4** is a simplified block diagram of an image capture device in an embodiment in accordance with the invention. Image capture device 400 is implemented as a digital camera in **FIG. 4****.** Those skilled in the art will recognize that a digital camera is only one example of an image capture device that can utilize an image sensor incorporating the present invention. Other types of image capture devices, such as, for example, cell phone cameras, scanners, and digital video camcorders can be used with the present invention.

In digital camera 400, light 402 from a subject scene is input to an imaging stage 404. Imaging stage 404 can include conventional elements such as a lens, a neutral density filter, an iris and a shutter. Light 402 is focused by imaging stage 404 to form an image on image sensor 406. Image sensor 406 captures one or more images by converting the incident light into electrical signals. Digital camera 400 further includes processor 408, memory 410, display 412, and one or more additional input/output (I/O) elements 414. Although shown as separate elements in the embodiment of **FIG. 4**, imaging stage 404 may be integrated with image sensor 406, and possibly one or more additional elements of digital camera 400, to form a camera module. For example, a processor or a memory may be integrated with image sensor 406 in a camera module in embodiments in accordance with the invention.

Processor 408 may be implemented, for example, as a microprocessor, a central processing unit (CPU), an application-specific integrated circuit (ASIC), a digital signal processor (DSP), or other processing device, or combinations of multiple such devices. Various elements of imaging stage 404 and image sensor 406 may be controlled by timing signals or other signals supplied from processor 408.

Memory 410 may be configured as any type of memory, such as, for example, random access memory (RAM), read-only memory (ROM), Flash memory, disk-based memory, removable memory, or other types of storage elements, in any combination. A given image captured by image sensor 406 may be stored by processor 408 in memory 410 and presented on display 412. Display 412 is typically an active matrix color liquid crystal display (LCD), although other types of displays may be used. The additional I/O elements 414 may include, for example, various on-screen controls, buttons or other user interfaces, network interfaces, or memory card interfaces. /

It is to be appreciated that the digital camera shown in **FIG. 4** may comprise additional or alternative elements of a type known to those skilled in the art. Elements not specifically shown or described herein may be selected from those known in the art. As noted previously, the present invention may be implemented in a wide variety of image capture devices. Also, certain aspects of the embodiments described herein may be implemented at least in part in the form of software executed by one or more processing elements of an image capture device. Such software can be implemented in a straightforward manner given the teachings provided herein, as will be appreciated by those skilled in the art.

Referring now to **FIG. 5****,** there is shown a simplified block diagram of image sensor 406 shown in **FIG. 4** in an embodiment in accordance with the invention. Image sensor 406 is implemented as a true two-phase full frame Charge Coupled Device (CCD) image sensor (described later) in **FIG. 4****.** Other embodiments in accordance with the invention are not limited to this type of image sensor. By way of example only, image sensor 406 may be implemented as an interline CCD image sensor, or a three or four phase CCD image sensor in other embodiments in accordance with the invention.

Image sensor 406 includes a number of pixels 500 typically arranged in rows and columns to form an imaging area 502. Each pixel 500 is configured as a shift element with each column of pixels forming a vertical shift register. After an image is captured by pixels 500, the accumulated charges are read out of imaging area 502. During image readout, the vertical shift registers shift each row of accumulated charges or signals out to horizontal shift register 504. Horizontal shift register 504 then sequentially shifts the charges to output amplifier 506.

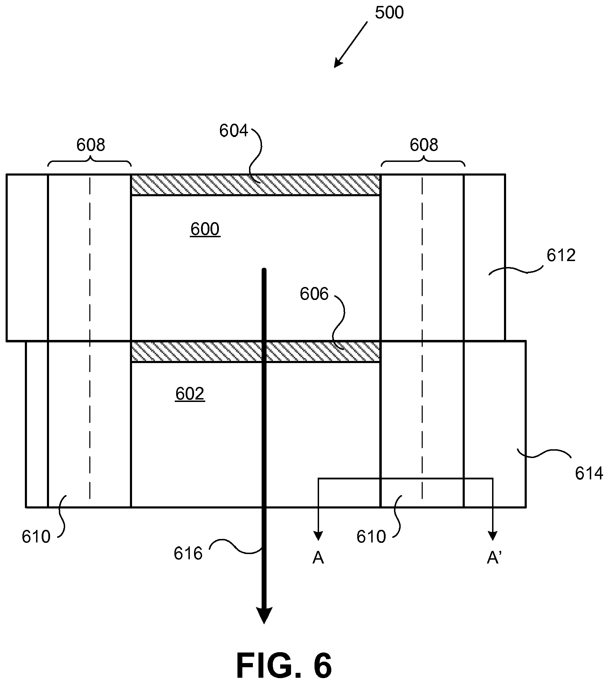

**FIG. 6** is a simplified diagram of pixel 500 shown in **FIG. 5** in an embodiment in accordance with the invention. As discussed earlier, image sensor 406 in **FIG. 5** is implemented as a true two-phase CCD image sensor. When a CCD image sensor includes multiple phases, the vertical CCDs are each separated into multiple parts or "phases" to facilitate the transfer of charge through the structures. Thus, in a true two-phase CCD, each shift element in a vertical CCD has a first phase shift element 600 and a second phase shift element 602.

Barrier regions 604, 606 separate each shift element 600, 602 in pixel 500 from vertically adjacent pixels and facilitate the transfer of charge through the vertical CCD. Channel stop 608 is formed within pixel 500 to prevent charge from spilling to horizontally adjacent pixels. Lateral overflow drain 610 (shown in dashed lines) is formed within channel stop 608, and is used to drain excess or undesirable charge from pixel 500. Lateral overflow drain 610 has a higher dopant concentration than the dopant concentration of channel stop 608 in an embodiment in accordance with the invention.

Overflow barrier regions are also formed in pixel 500. The overflow barrier regions are not shown in **FIG. 6** for the sake of clarity. Overflow barrier regions can be designed and fabricated using any known fabrication method. Overflow barrier regions are described, for example, in United States Patents 5,130,774 and 5,349,215.

And finally, gate electrodes 612, 614 are formed over pixel 500 and are made of a transparent material that allows light to pass through electrodes 612, 614. Examples of a transparent material include, but are not limited to, polysilicon and indium-tin-oxide (ITO). Gate electrodes 612, 614 activate the transfer of charge through shift elements 600, 602. A voltage is alternately applied to each gate electrode 612, 614 to shift charge from one shift element to the next shift element. Arrow 616 indicates the direction of the charge transfer through each vertical shift register.

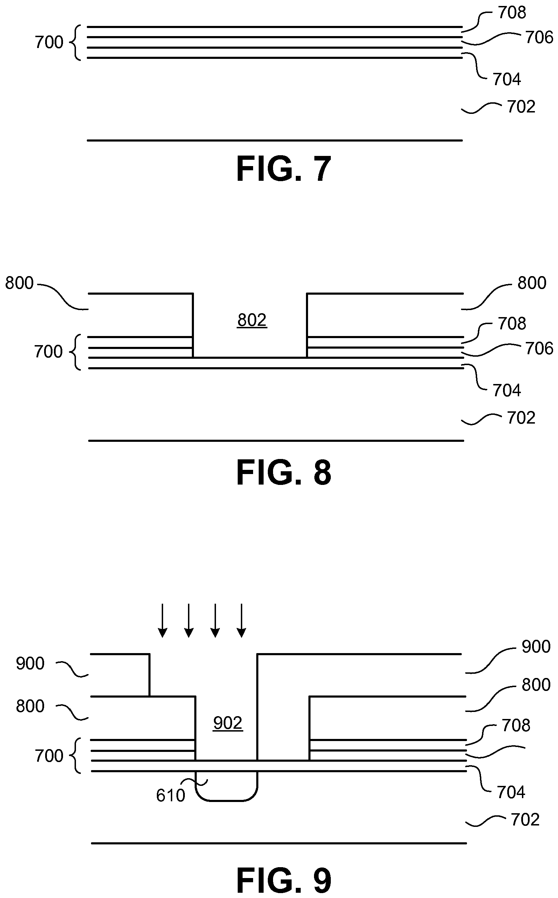

Referring now to **FIGS. 7-12****,** there are shown cross section views of a portion of pixel 500 along line A-A' in **FIG. 6** that illustrate a method of forming lateral overflow drain 610 and channel stop 608 in an example not forming part of the claimed invention. **FIG. 7** depicts a portion of a pixel after a number of initial fabrication steps have been completed. The pixel at this stage includes an insulating layer 700 formed over layer 702. By way of example only, insulating layer 700 is implemented as an oxide-nitride-oxide (ONO) layer (layers 704, 706, and 708, respectively) in an embodiment in accordance with the invention. Layer 702 is configured as a substrate, layer, or well having either an n or p conductivity type.

Hard mask layer 800 is then formed over insulating layer 700 and patterned to form opening 802 (**FIG. 8**). By way of example only, hard mask layer 800 can be formed as a silicon nitride or silicon dioxide layer. The portions of oxide layer 708 and nitride layer 706 that are exposed in opening 802 are removed. Oxide layer 704 is not removed and acts as a protection and screening layer.

A second mask layer 900 is then formed on hard mask layer 800 and patterned to form opening 902 (**FIG. 9**). Second mask layer 900 is formed by depositing a photoresist on hard mask layer 800.

Opening 902 resides in a portion of opening 802 with second mask layer 900 filling in the remaining portion of opening 802.

One or more dopants are then implanted into layer 702 (represented by arrows) to form lateral overflow drain 610. The dopant or dopants used to form lateral overflow drain 610 are of the opposite conductivity type from the conductivity type of layer 702. For example, if layer 702 includes p-type dopants, then lateral overflow drain 610 is formed with n-type dopants. Arsenic is an exemplary n-type dopant that can be implanted with a concentration of 1x10¹⁴ atoms per square centimeter to form lateral overflow drain 610.

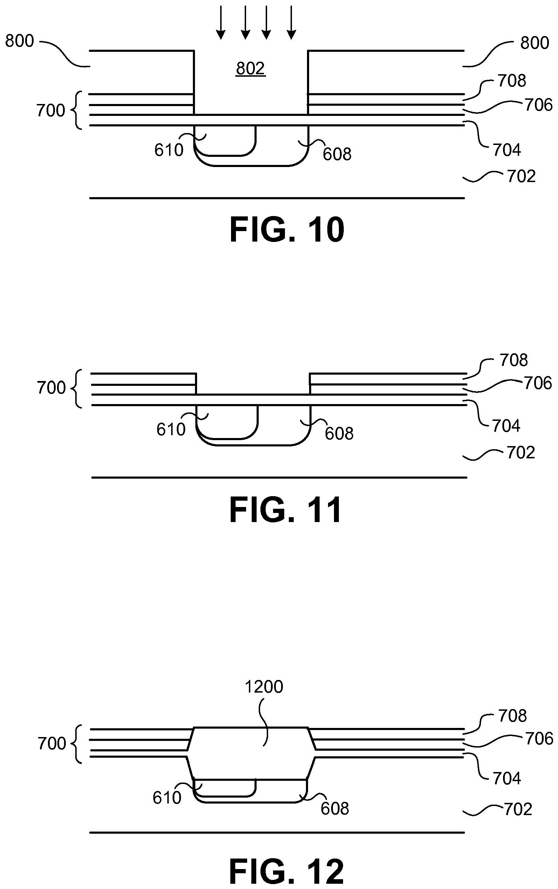

Next, as shown in **FIG. 10**, mask layer 900 is removed and one or more dopants are implanted (represented by arrows) through opening 802 and into lateral overflow drain 610 and an adjoining portion of layer 702 to form channel stop 608. The one or more dopants used to form channel stop 608 have the same conductivity type as layer 702. For example, if layer 702 has p-type conductivity, the dopant or dopants used to form channel stop 608 are p-type dopants in an embodiment in accordance with the invention. By way of example only, boron is a p-type dopant that can be implanted with a concentration of 1x10¹³ atoms per square centimeter to form channel stop 608.

Due to the use of two mask layers 800 and 900, one edge of lateral overflow drain 610 is aligned, or substantially aligned, with an edge of channel stop 608. Hard mask layer 800 is then removed, resulting in the structure shown in **FIG. 11****.** A field oxide region 1200 is formed over channel stop 608 and lateral overflow drain 610 (**FIG. 12**). Field oxide region 1200 can be formed using any known method. Pixel 500 can now be processed further. Subsequent processing steps may include the formation of a buried channel, an overflow barrier region disposed adjacent to lateral overflow drain 610, and an overlying gate electrode.

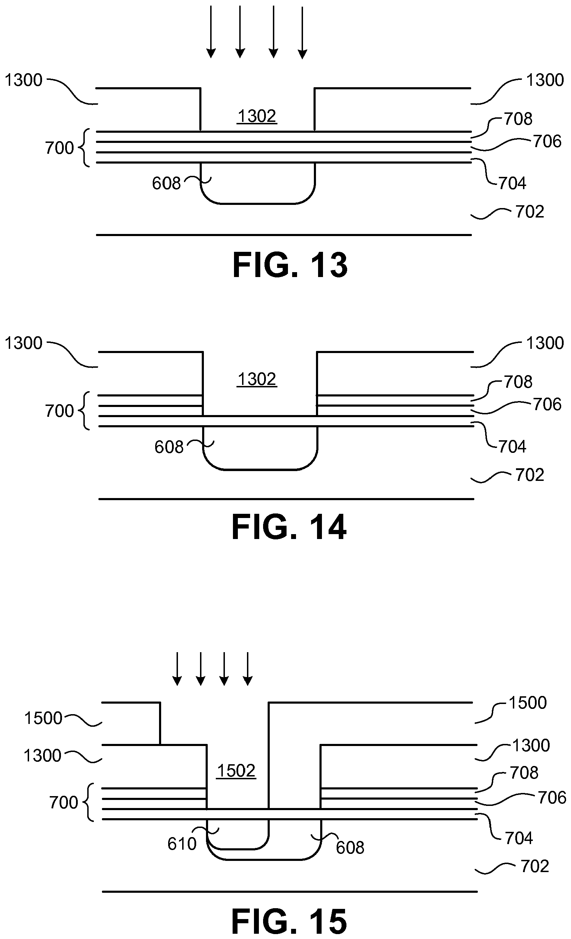

**FIGS. 13-15** are cross section views of a portion of pixel 500 along line A-A' in **FIG. 6** illustrating alternate techniques that can be performed instead of the techniques shown in **FIGS. 8-10** in an embodiment in accordance with the invention. The processing step shown in **FIG. 13** is performed after **FIG. 7****.** Mask layer 1300 is formed on insulating layer 700 and patterned to create first opening 1302 (**FIG. 13**). Mask layer 1300 is formed by depositing a photoresist over insulating layer 700 in an embodiment in accordance with the invention. In another embodiment in accordance with the invention, mask layer 1300 is formed by depositing a hard mask layer over insulating layer 700.

One or more dopants are then implanted (represented by arrows) through opening 1302 and into layer 702 to form channel stop 608. The one or more dopants used to form channel stop 608 have the same conductivity type as layer 702. For example, if layer 702 has p-type conductivity, the dopant or dopants used to form channel stop 608 are p-type dopants in an embodiment in accordance with the invention. Boron is an exemplary p-type dopant that can be implanted with a concentration of 1x10¹³ atoms per square centimeter to form channel stop 608. In another embodiment in accordance with the invention, one or more n-type dopants can be used to form channel stop 608 when layer 702 has an n-type conductivity.

Next, as shown in **FIG. 14****,** oxide layer 708 and nitride layer 706 that are exposed in opening 1302 are removed. Oxide layer 708 and nitride layer 706 are etched with a plasma etch in an embodiment in accordance with the invention. Oxide layer 704 is not removed and acts as a protection and screening layer in an embodiment in accordance with the invention.

Mask layer 1500 is then formed over mask layer 1300 and patterned to create second opening 1502 **(****FIG. 15****).** Mask layer 1500 is formed by depositing a photoresist over mask layer 1300 in an embodiment in accordance with the invention. Second opening 1502 is disposed in a portion of first opening 1302, and a portion of mask layer 1500 is disposed in the remaining portion of opening 1302.

One or more dopants are then implanted (represented by arrows) through opening 1502 and into channel stop 608 to form lateral overflow drain 610. Due to the dual-mask layers 1300 and 1500, only one edge of a footprint of lateral overflow drain 610 is aligned with an edge of the footprint of channel stop 608. The dopant or dopants used to form lateral overflow drain 610 are of the opposite conductivity type from channel stop 608. For example, if channel stop 608 includes p-type dopants, then lateral overflow drain 610 is formed with n-type dopants. By way of example only, arsenic is an n-type dopant that can be implanted with a concentration of 1x10¹⁴ atoms per square centimeter to form lateral overflow drain 610.

Mask layer 1500 and mask layer 1300 in **FIG. 15** are removed after lateral overflow drain 610 is formed, resulting in the pixel structure depicted in **FIG. 11****.** Field oxide region 1200 is now formed over channel stop 608 and lateral overflow drain 610, as shown in **FIG. 12****.** Field oxide region 1200 can be formed using any known method. Pixel 500 can now be processed further. Subsequent processing steps may include the formation of a buried channel, an overflow barrier region disposed adjacent to lateral overflow drain 610, and an overlying gate electrode.

Lateral overflow drains 610 and channel stops 608 formed by the methods shown in **FIGS. 7-15** can have smaller dimensions than prior art structures. This is because the sizes of opening 902 in **FIG. 9** and opening 1502 in **FIG. 15** are smaller than the achievable minimum sizes for openings 802 (**FIG. 8**) and 1302 **(****FIG. 13****).** When formed using conventional lithography techniques, the smallest dimensions for openings 802 and 1302 are defined and constrained by the minimum dimensions that can be obtained with conventional lithography. But, since openings 902 and 1502 are formed within openings 802 and 1302, respectively, openings 902 and 1502 have smaller dimensions than openings 802 and 1302. Thus, the present invention provides accurate and repeatable methods for fabricating lateral overflow drains and channel stops with minimal feature sizes.

The invention has been described with reference to particular embodiments in accordance with the invention. By way of example only, the order in which the fabrication steps shown in **FIG. 8** and in **FIGS. 9-10** can be reversed. Thus, oxide layer 708 and nitride layer 706 that are exposed in opening 802 are removed after the formation of lateral overflow drain 610 and channel stop 608. Additionally, the conductivity types of layer 702 and channel stop 608 can be n-type while the conductivity type of lateral overflow drain is p-type.

### PARTS LIST

- 100: insulating layer
- 102: substrate, layer, or well
- 104: nitride layer
- 200: mask layer
- 202: portion of insulating layer
- 204: channel stop
- 300: mask layer
- 302: portion of insulating layer
- 304: lateral overflow drain
- 306: overlap area
- 308: portion of insulating layer
- 400: image capture device
- 402: light
- 404: imaging stage
- 406: image sensor
- 408: processor
- 410: memory
- 412: display
- 414: other input/output (I/O) elements
- 500: pixel
- 502: imaging area
- 504: horizontal shift register
- 506: output amplifier
- 600: shift element
- 602: shift element
- 604: barrier region
- 606: barrier region
- 608: channel stop
- 610: lateral overflow drain
- 612: gate electrode
- 614: gate electrode
- 616: arrow representing direction of charge transfer
- 700: insulating layer
- 702: layer
- 704: oxide layer
- 706: nitride layer
- 708: oxide layer
- 800: hard mask layer
- 802: opening
- 900: second mask layer
- 902: opening
- 1200: field oxide
- 1300: mask layer
- 1302: opening
- 1500: mask layer
- 1502: opening

## Claims

1. A method of fabricating a CCD image sensor (406) including one or more lateral overflow drains (610), the method comprising:
forming a first mask layer (1300) over an insulating layer (700), wherein the insulating layer (700) is disposed on a layer (702) having a first conductivity type;
patterning the first mask layer to create one or more first openings (1302) where channel stops (608) will be formed;
implanting one or more dopants of the first conductivity type through the one or more first openings and into the layer having the first conductivity type to form the one or more channel stops (608) in the layer having the first conductivity type;
removing a portion (706, 708) of the insulating layer (700) exposed in the one or more first openings prior to forming a second mask layer (1500) over the first mask layer (1300) and the one or more first openings;
patterning the second mask layer to create one or more second openings (1502) where the one or more lateral overflow drains (610) will be formed, wherein each second opening (1502) is disposed in a portion of a respective first opening (1302) and a portion of the second mask layer is disposed in the remaining portion of each first opening; and
implanting one or more dopants of a second conductivity type opposite the first conductivity type through the one or more second openings and into each channel stop to form the one or more lateral overflow drains (610) disposed entirely within a footprint of the channel stop,
**characterised in that**:
removing the portion (706, 708) of the insulating layer comprises removing only a portion (706, 708) of the insulating layer (700) exposed in the one or more first openings such that the insulating layer (704) after removal of said portion acts as a protection layer in subsequent processing steps for the surface of the layer (702) having the first conductivity type; and
implanting the one or more dopants of the second conductivity type forms the one or more lateral overflow drains (610) with only one edge of a footprint of the lateral overflow drain aligned with an edge of the footprint of the channel stop.

2. The method of claim 1, further comprising removing the first and second mask layers (1300, 1500).

3. The method of claim 2, further comprising forming a field oxide region (1200) over each channel stop and associated lateral overflow drain.

4. A CCD image sensor (406) comprising
a lateral overflow drain (610) formed entirely within a footprint of a channel stop (608) disposed in a layer (702),
**characterised in that** only one edge of a footprint of the lateral overflow drain (610) is aligned with an edge of the footprint of the channel stop (608).

## Patentansprüche

1. Verfahren zum Herstellen eines CCD-Bildsensors (406), einschließlich eines oder mehrerer Seitenüberlaufdrains (610), wobei das Verfahren Folgendes umfasst:
Ausbilden einer ersten Maskenschicht (1300) über einer Isolierschicht (700), wobei die Isolierschicht (700) auf einer Schicht (702) mit einem ersten Leitfähigkeitstyp angeordnet ist;
Mustern der ersten Maskenschicht, um eine oder mehrere erste Öffnungen (1302) auszubilden, wo Kanalbegrenzer (608) ausgebildet werden;
Implantieren eines oder mehrerer Dotierstoffe des ersten Leitfähigkeitstyps durch die eine oder die mehreren ersten Öffnungen und in die Schicht mit dem ersten Leitfähigkeitstyp, um den einen oder die mehreren Kanalbegrenzer (608) in der Schicht mit dem ersten Leitfähigkeitstyp auszubilden;
Entfernen eines Teils (706, 708) der in der einen oder den mehreren ersten Öffnungen freiliegenden Isolierschicht (700) vor dem Ausbilden einer zweiten Maskenschicht (1500) über der ersten Maskenschicht (1300) und der einen oder den mehreren ersten Öffnungen;
Mustern der zweiten Maskenschicht, um eine oder mehrere zweite Öffnungen (1502) auszubilden, wobei der eine oder die mehreren Seitenüberlaufdrains (610) ausgebildet werden, wobei jede zweite Öffnung (1502) in einem Teil einer entsprechenden ersten Öffnung (1302) angeordnet ist und ein Teil der zweiten Maskenschicht in dem verbleibenden Teil jeder ersten Öffnung angeordnet ist; und
Implantieren eines oder mehrerer Dotierstoffe eines zweiten Leitfähigkeitstyps gegenüber dem ersten Leitfähigkeitstyp durch die eine oder die mehreren zweiten Öffnungen und in jeden Kanalbegrenzer, um den einen oder die mehreren Seitenüberlaufdrains (610), die vollständig in einem Auswirkungsbereich des Kanalbegrenzers angeordnet sind, auszubilden,
**dadurch gekennzeichnet, dass**:
das Entfernen des Teils (706, 708) der Isolierschicht das Entfernen nur eines Teils (706, 708) der in der einen oder den mehreren ersten Öffnungen freiliegenden Isolierschicht (700) umfasst, sodass die Isolierschicht (704) nach dem Entfernen des Teils in nachfolgenden Bearbeitungsschritten für die Oberfläche der Schicht (702) mit dem ersten Leitfähigkeitstyp als eine Schutzschicht wirkt; und
das Implantieren des einen oder der mehreren Dotierstoffe des zweiten Leitfähigkeitstyps den einen oder die mehreren lateralen Überlaufdrains (610) mit nur einer Kante eines Auswirkungsbereichs des lateralen Überlaufdrains, der an einer Kante des Auswirkungsbereichs des Kanalbegrenzers ausgerichtet ist, ausbildet.

2. Verfahren nach Anspruch 1, ferner umfassend das Entfernen der ersten und der zweiten Maskenschicht (1300, 1500).

3. Verfahren nach Anspruch 2, ferner umfassend das Ausbilden eines Feldoxidbereichs (1200) über jedem Kanalbegrenzer und verbundenen lateralen Überlaufdrain.

4. CCD-Bildsensor (406), Folgendes umfassend:
einen lateralen Überlaufdrain (610), der vollständig in einem Auswirkungsbereich eines in einer Schicht (702) angeordneten Kanalbegrenzers (608) ausgebildet ist, **dadurch gekennzeichnet, dass** nur eine Kante eines Auswirkungsbereichs des lateralen Überlaufdrains (610) an einer Kante des Auswirkungsbereichs des Kanalbegrenzers (608) ausgerichtet ist.

## Revendications

1. Procédé de fabrication d'un capteur d'image CCD (406) comportant un ou plusieurs drains de trop-plein latéraux (610), le procédé comprenant :
la formation d'une première couche de masque (1300) par-dessus une couche isolante (700), dans lequel la couche isolante (700) est disposée sur une couche (702) ayant un premier type de conductivité ;
le modelage des contours de la première couche de masque pour créer une ou
plusieurs premières ouvertures (1302) où des arrêts de canal (608) seront formés ;
l'implantation d'un ou plusieurs dopants du premier type de conductivité à travers les une ou plusieurs premières ouvertures et dans la couche ayant le premier type de conductivité pour former les un ou plusieurs arrêts de canal (608) dans la couche ayant le premier type de conductivité ;
le retrait d'une partie (706, 708) de la couche isolante (700) exposée dans les une ou
plusieurs premières ouvertures avant de former une seconde couche de masque (1500) par-dessus la première couche de masque (1300) et les une ou
plusieurs premières ouvertures ;
le modelage des contours de la seconde couche de masque pour créer une ou
plusieurs secondes ouvertures (1502) où les un ou plusieurs drains de trop-plein latéraux (610) seront formés, dans lequel chaque seconde ouverture (1502) est disposée dans une partie d'une première ouverture (1302) respective et une partie de la seconde couche de masque est disposée dans la partie restante de chaque première ouverture ; et
l'implantation d'un ou plusieurs dopants d'un second type de conductivité opposé au premier type de conductivité à travers les une ou plusieurs secondes ouvertures et
dans chaque arrêt de canal pour former les un ou plusieurs drains de trop-plein latéraux (610) disposés entièrement dans une empreinte de l'arrêt de canal,
**caractérisé en ce que** :
le retrait de la partie (706, 708) de la couche isolante comprend le retrait uniquement d'une partie (706, 708) de la couche isolante (700) exposée dans les une ou
plusieurs premières ouvertures de sorte que la couche isolante (704) après retrait de ladite partie serve de couche de protection dans des étapes de traitement ultérieures pour la surface de la couche (702) ayant le premier type de conductivité ; et
l'implantation des un ou plusieurs dopants du second type de conductivité forme les un ou plusieurs drains de trop-plein latéraux (610) avec uniquement un bord d'une empreinte du drain de trop-plein latéral aligné avec un bord de l'empreinte de l'arrêt de canal.

2. Procédé selon la revendication 1, comprenant en outre le retrait des première et seconde couches de masque (1300, 1500).

3. Procédé selon la revendication 2, comprenant en outre la formation d'une région d'oxyde de champ (1200) par-dessus chaque arrêt de canal et drain de trop-plein latéral associé.

4. Capteur d'image CCD (406) comprenant
un drain de trop-plein latéral (610) formé entièrement dans une empreinte d'un arrêt de canal (608) disposé dans une couche (702),
**caractérisé en ce qu'**uniquement un bord d'une empreinte du drain de trop-plein latéral (610) est aligné avec un bord de l'empreinte de l'arrêt de canal (608).
